# EUROPEAN PATENT APPLICATION

(11) **EP 1 715 552 A1**
(43) Date of publication of application: **25.10.2006**
(21) Application number: 05103273.8
(22) Date of filing: 22.04.2005
(51) Int. Cl.: H01R 31/06

(54) **Adapter providing an interconnection between an add-in card and a connector slot of a computer system**

(71) Applicant: Agilent Technologies Inc, Palo Alto, 5 94306 (US)
(72) Inventor: BERL, Heinz, 71083, Herrenberg (DE)
(74) Representative: Neuerburg, Gerhard

(57) **Abstract**

The invention relates to an adapter (10) for adapting an add-in card (26) to a connector slot of a computer system, comprising a first rigid board (12) having electrical contacts (14) and being adapted to be inserted in the connector slot, a second rigid board (16) with a first connector part (30) of a connector (28) mounted on one side of the second board (16), a flexible board (18) fixed on one end to the first rigid board (12) and on the opposite end to the second rigid board (16), wherein the flexible board (18) comprises electrical connections (20) connecting the electrical contacts (14) of the first rigid board (12) with electrical contacts of the first connector part (30), and at least one support part (22, 24; 34) fixedly joining the first and second rigid board (12, 16) and being adapted to be joint with the add-in card (26), wherein the at least one support part (22, 24) is designed such that the first and second rigid board (12, 16) are mechanically offset in that the first connector part (30) is connectable with a second connector part (32) mounted on one side of the add-in card (26), and the first rigid board (12) is aligned with the add-in card (26) so that the add-in card (26) is insertable in the connector slot.

## Description

### BACKGROUND ART

The present invention relates to an adapter for interconnecting an add-in card with a connector slot of a computer system.

Computer systems such as an IBM-compatible Personal Computer - PC - usually comprise an expansion bus for connecting peripheral components with the computer system. The expansion busses in PCs encompass relatively slow input-output- or I/O-busses such as the ISA (Industry Standard Architecture) bus, the MCA (Micro Channel Architecture) bus, or the EISA (Extended Industry Standard Architecture) bus, and the faster local busses such as the VL (VESA local), the PCI (Peripheral Component Interconnect) bus or the AGP (Advanced Graphics Port) bus. A recent development is the PCI Express^{™} bus which supports a data rate of 2.5 GB/s per direction.

A typical PC comprises expansion slots for receiving so called add-in cards which are connected with an expansion bus of the PC. For coupling, an add-in card such as a SCSI card or a graphics card comprises an adapter which can be inserted in a vertical edge-card connector of an expansion slot. The adapter of the add-in card has to comply with the bus specification. Also, the add-in card should meet mechanical specifications of the bus standard in order to be applicable in different PC chassis. Particularly, the dimensions of the card should comply with mechanical specifications such as the length, height, and thickness of the card. For example, the PCI Express^{™} Card Electromechanical Specification Revision 1.0a, April 15, 2003, defines several add-in card sizes depending on the link width of the adapter of a card.

For some applications such as test and measurement equipment for computer systems, add-in cards with different adapters used for insertion in different vertical edge-card connectors are required. However, this is costly, since for each vertical edge-card connector a specific card has to be provided. Instead of different add-in cards, adapters which are adapted to be used with the different vertical edge-card connectors and connectable to the board of an add-in card can be used.

However, such adapter adapters must be connected to the board of an add-in card with high-speed connectors if signals with high data rates are transmitted via the adapter to the board. For example, in case of the PCI Express^{™} bus, a high-speed connector must be able to transmit signals in a frequency range up to 2.5 GB/s. Such high-speed connectors typically require a lot of space if mounted on one side of the board of an add-in card. Therefore, an add-in card with such an adapter usually occupies more than one expansion slots.

### DISCLOSURE OF THE INVENTION

It is an object of the present invention to provide an improved adapter for providing an interconnection between an add-in card and a connector slot of a computer system that can be removably coupled to boards of different add-in cards. The object is solved by the independent claim. Preferred embodiments are shown by the dependent claims.

A basic idea of the invention is to split an adapter for adapting an add-in card for a connector slot of a computer system into two rigid boards, and to electrically connect the two boards with a flexible board. One of the two rigid boards may be used as a connector to be inserted into a vertical edge-card connector of an expansion slot of a computer system. The other one of the two rigid boards may be removably coupled to a board of an add-in card for the expansion slot. The flexible board allows to offset the two rigid boards such that a connector, which is mounted on one side of the add-in card, may be used to electrically couple the add-in card with the adapter while only one expansion slot of the computer system is occupied.

According to embodiments of the invention, an adapter, also referred to as edge connector, for adapting an add-in card to a connector slot of a computer system comprises a first rigid board having electrical contacts and being adapted to be inserted in the connector slot, a second rigid board with a first connector part of a connector mounted on one side of the second board, and a flexible board fixed on one end to the first rigid board and on the opposite end to the second rigid board. The flexible board comprises electrical connections connecting the electrical contacts of the first rigid board with electrical contacts of the first connector part. The adapter further comprises at least one support part fixedly joining the first and second rigid board and being adapted to be joined with the add-in card. The at least one support part is designed such that the first and second rigid board are mechanically offset in that the first connector part is connectable with a second connector part mounted on one side of the add-in card, and the first rigid board is aligned with the add-in card so that the add-in card is insertable in the connector slot. This embodiment has the advantage that mechanical specifications of the connector slot may be met, and, furthermore, the adapter may be used with different add-in cards.

The flexible board may be fixed on the side of the second rigid board, which is opposite to the side with the first connector part. According to an alternative embodiment, the flexible board may be fixed on the side of the second rigid board, on which the first connector part is mounted. According to a further embodiment, the end of the flexible board may be fixed to the second rigid board in that it is "sandwiched" between two layers of the second rigid board.

In a preferred embodiment, the at least one support part comprises alignment means for aligning the adapter with the add-in card in order to avoid any misalignments when coupling the adapter to the add-in card which could negatively influence the signal transmission from the adapter to the add-in card.

Preferably, the alignment means comprise at least two bores in the at least one support part; the at least two bores are adapted to receive sleeves fixedly joint to the add-in card. This solution results in a mechanical relatively robust coupling of the add-in card and the adapter, which can withstand the forces occurring during removing or inserting the add-in card from or into a connector slot of a computer system.

In a further preferred embodiment, the second rigid board may comprise a second first part of a connector, mounted on the side of the second rigid board which is opposite to the side, on which the first connector part is mounted. Thus, a further add-on card may be electrically connected on top of the add-in card connected to the adapter.

Preferably, the adapter is a Peripheral Component Interconnect - PCI - Express adapter adapted for insertion in a PCI Express slot of a computer system. According to the PCI Express specification, a data rate of up to 2.5 GB/s is transmitted from a PCI Express bus of a computer system to an add-in card and vice versa. Thus, the electrical connections between the bus and the add-in card are highly sensitive with regard to the quality of transmitted signals. In order to achieve a sufficient signal quality, high-speed connectors should be used. The invention allows to use such high-speed connectors which are highly sensitive to misalignments between an adapter and an add-in card.

Preferably, the bus specification is PCI Express and the adapter contains one to 16 PCI Express lanes.

In a preferred embodiment, an add-in card with the adapter complies with PCI Express mechanical specifications.

Typically, the first connector part may be the header of a connector and the second connector part may be the socket of the connector.

Preferably, the connector is a high-speed connector adapted to transmit signals in a frequency range up to 2.5 GB/s

According to a further embodiment of the invention, an add-in card for a connector slot of a computer system comprises an adapter according to the invention.

In a further embodiment, the invention relates to a computer system comprising a system board with a bus, which includes at least one expansion slot comprising an add-in card according to the invention.

### BRIEF DESCRIPTION OF DRAWINGS

Other objects and many of the attendant advantages of embodiments of the present invention will be readily appreciated and become better understood by reference to the following more detailed description of embodiments in connection with the accompanied drawing(s). Features that are substantially or functionally equal or similar will be referred to by the same reference sign(s).

Fig. 1 shows a first embodiment of an adapter according to the invention and coupled to an add-in card, in a perspective view;

Fig. 2 shows the adapter of Fig. 1 coupled to an add-in card in a side view;

Fig. 3 shows an embodiment of the adapter according to the invention in a view from the bottom side with the header part of a high-speed connector, wherein the adapter comprises two support bars fixedly joining the first and second board of the adapter;

Fig. 4 shows an embodiment of the adapter according to the invention in a view from the bottom side with the header part of a high-speed connector, wherein the adapter comprises one support bar fixedly joining the first and second board of the adapter;

Fig. 5 shows a side view of the connection of the flexible board and the second board according to an embodiment of the invention, wherein one end of the flexible board forms a layer of the second rigid board of the adapter;

Fig. 6 shows a side view of the connection of the flexible board and the second board according to an embodiment of the invention, wherein one end of the flexible board is mounted between the second rigid board of the adapter and a part of second high-speed connector;

Fig. 7 shows side views and top views of two alternative solutions of the connection of the flexible board and the first board according to the invention;

Fig. 8 shows an embodiment of a support part of the adapter according to the invention, in a perspective view; and

Fig. 9 shows a second embodiment of an adapter according to the invention and coupled to an add-in card, in a perspective view.

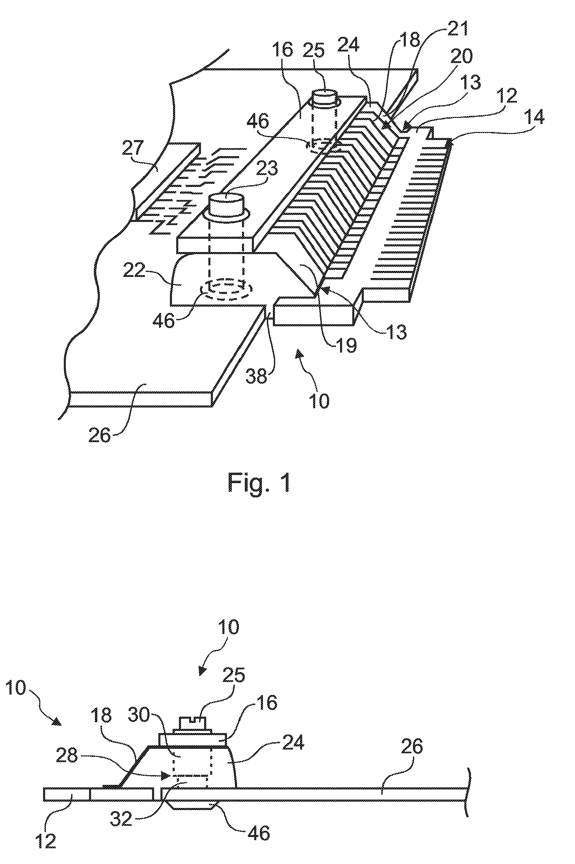

Fig. 1 shows an adapter 10 for an add-in card 26 implementing a protocol tester for the PCI Express^{™} bus. The card 26 contains a FPGA (Field Programmable Gate Array) chip 27 adapted for performing protocol test functions of the PCI Express ^{™} bus. The card 26 may be a standard x16 adapter PCI main board defined by the PCI Express^{™} standards guideline with a thickness of 1.6 mm. It may be a multilayer board which comprises a socket 32 of an high-speed connector 28 for electrically connecting the chip 27 with the PCI Express^{™} bus and routing high data rate signals from the chip 27 to the bus and vice versa.

The adapter 10 is electrically coupled to the PCI Express^{™} bus via a vertical edge-card connector (not shown) in which the adapter 10 is inserted. The vertical edge-card connector may be of the kind as used in ATX or ATX-based computer systems. It may one of a family of connectors, containing one to 16 PCI Express^{™} lanes depending on the required bandwidth. For example, a vertical edge-card connector with 16 PCI Express^{™} lanes has a high bandwidth and may be used for add-in cards that require a high bandwidth such as graphic cards.

The adapter 10 may be removable joint with the add-in card 26 by screws 23 and 25. Thus, it is possible to use the add-in card 26 for testing different bus widths by simply mounting an adapter 10 with a suitable bandwidth to the add-in card 26. The adapter 10 is designed to pass signals with a high data rate up to several GHz. Further, it may be easily removed from the add-in card, and is robust in order to withstand the mechanical forces occurring during insertion or removal of the add-in card 26 into or from a computer slot.

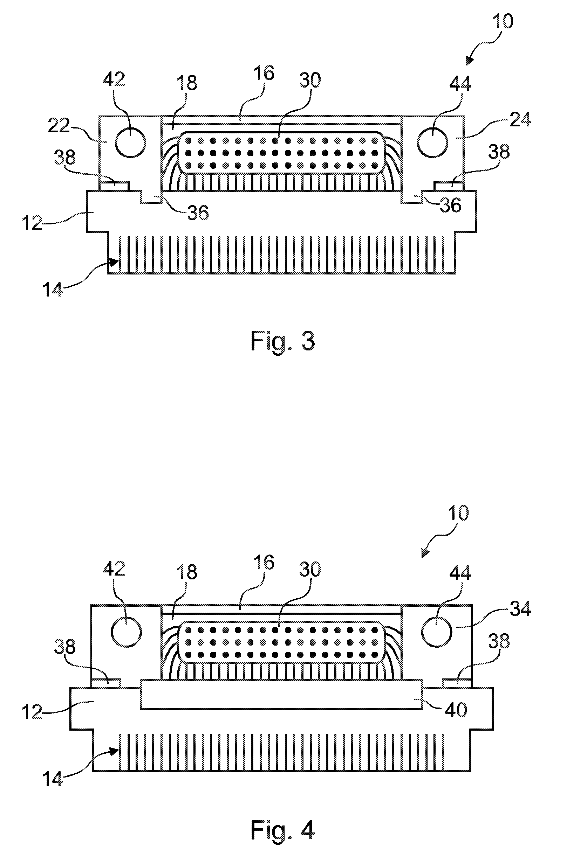

The adapter 10 comprises a first rigid board 12 with electrical contacts 14 mating with electrical contacts of a vertical edge-card connector of an expansion bus of a computer system. The first rigid board 12 may be adapted to conform with the PCI Express^{™} standard and, thus, contain one to 16 PCI Express lanes, i.e., have a link width of x1, x4, x8, or x16. The first rigid board 12 is glued (reference numeral 13) to metal, e.g., Aluminium support parts 22 and 24, which are formed like bars with an inclined side 19 and 21, respectively. The support bars 22 and 24 contain bores 42 and 44 (Fig. 3) for receiving sleeves 46 mounted to the add-in card 26. The adapter 10 is fixed at the add-in card 26 by screws 23 and 25.

The support bars 22 and 24 hold a second rigid board 16 of the adapter 12, which is fixed at the support bars 22 and 24 by the glue. The second rigid board 16 is electrically connected to the first rigid board 12 by a flexible board 18, e.g., a flex foil with a copper layer for the electrical connection lines between the first and second rigid board. The flexible board 18 comprises electrical connections 20 which route signals from the first to the second rigid board 12 and 16, respectively, and vice versa. It should be noted that the electrical connections of the first and second rigid board and the flexible board 12, 16, and 18, respectively, are designed such that they can route signals with a data rate up to 2.5 GB/s, i.e., signals with a frequency range up to several GHz. The flexible board 18 is guided along the inclined sides 19 and 21 in order to avoid bends of the flexible board 18 which could negatively influence the electrical characteristics of its electrical connections 20. For example, the inclined sides 19 and 21 are designed such that the smallest bend radius may be not smaller than 2 mm.

On the side of the second rigid board 16, which is opposite to the surface of the add-in card 26, a header 30 of a high-speed connector 28 as a first connector part of a connector is mounted, as can be seen in Fig. 2. The header 30 of the high-speed connector 28 may be a QTE series 0,80 mm high-speed header of Samtec, Inc., New Albany, IN, further referred to as Samtec (e.g., part numbers QTE-060-01-L-D-A, QTE-020-03-F-D-A, QTE-040-02-L-D-A). This header allows passing signals with a frequency up to 5 GHz if the signals are transmitted via a differential pair of signals lines. The header 30 mates with a high-speed socket 32 as second connector part of the high-speed connector 28. The socket 32 is mounted on the side of the add-in card 26 on which the metal support bars 22 and 24 rest. The socket 32 of the high-speed connector 28 may be a QSE series 0,80 mm high-speed socket of Samtec (e.g., part numbers QSE-020-01-L-D-A, QSE-060-01-F-D-A, QSE-040-01-F-D-A).

In order to align the adapter 10 when joining it to the add-in card 26, the add-in card 26 comprises two sleeves 46 fixed at it. Each of the two sleeves 46 comprises an inside thread for a screws. The sleeves 46 are adapted to fit into the bores of the support bars 22 and 24 such that the sleeves 46 have less loose in the bores. For coupling the adapter 10 at the add-in card 26, the sleeves 46 of the add-in card 26 are inserted into the bores of the support bars 22 and 24 of the adapter 10. Then, the header 30 of the high-speed connector 28 is plugged in the socket 32. Finally, the screws 23 and 25 are driven in the sleeves 46 such that the adapter 10 is fixedly joint with the add-in card 26. When inserting or removing the add-in card 26 together with the adapter 10 into or from a connector slot of a computer system, occurring forces are substantially borne by the sleeves 46 and screws 23 and 25.

Fig. 3 shows a view of the bottom side of an embodiment of the adapter 10 of Fig. 1. The view shows the header 30 of a high-speed connector mounted on the bottom side of the second rigid board 16. The header 30 is electrically connected with the flexible board 18, which is arranged between the header 30 and the second rigid board 16. On the left and right side of the header 30, two separate support bars 22 and 24 are fixed to the first rigid board 12 and the second rigid board 16 with glue. The support bars 22 and 24 comprise bores 42 and 44 for the insertion of sleeves 46 and alignment means 36 for the first rigid board 12. Furthermore, they comprise spacer 38 which are arranged between the first rigid board 12 and the add-in card 26 when the adapter 10 is joined with the add-in card 26.

Fig. 4 shows a view of the bottom side of a further embodiment of the adapter 10 according to the invention. The shown adapter 10 comprises a single support part 34, which comprises two support bars similar to the two separate support bars of the embodiment shown in Fig. 3. The single support part 34 further comprises a portion 40 on which the first rigid board 12 is fixed with glue. The portion 40 may also serve for aligning the first rigid board 12 and the single support part 34.

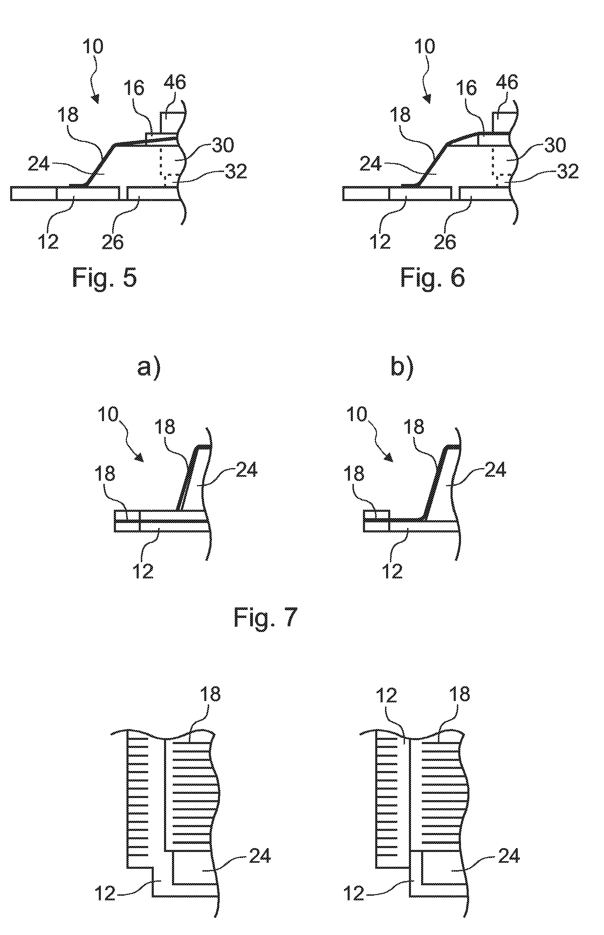

Now, referring to Fig. 5 and 6, the connection of the flexible board 18 to the second rigid board 16 according to the invention is discussed in more detail. Fig. 5 shows a side view of an adapter 10 according to the invention coupled to an add-in card 26. The end of the flexible board 18, which electrically connects the first and second rigid board 12 and 16, respectively, is "sandwiched" between two layers of the second rigid board 16. The second rigid board 16 contains two parts 30 and 42 of two high-speed connectors. The first part 30 is the header of a high-speed connector, which electrically connects the adapter 10 with the add-in card 26. The second part is mounted on top of the second rigid board 16 and provided for electrically connecting the adapter 10 with a second add-in card (not shown), which may be mounted on top of the add-in card 26. In contrast to Fig. 5, Fig. 6 shows an embodiment in which the flexible board 18 is mounted between the second rigid board 16 and the part 42 of the second high-speed connector. For example, the flexible board 18 may be fixed by glue, by soldering it to the second rigid board 16, or by clipping it between the second rigid board 16 and the high-speed connector part 42.

Fig. 7 shows two different embodiments of the connection of the flexible board 18 to the first rigid board 12. Fig. 7 a) shows the presently preferred embodiment in which the flexible board 18 forms one layer of the first rigid board 12. In Fig. 7 b), the flexible board 18 is "sandwiched" between two parts of the first rigid board 12.

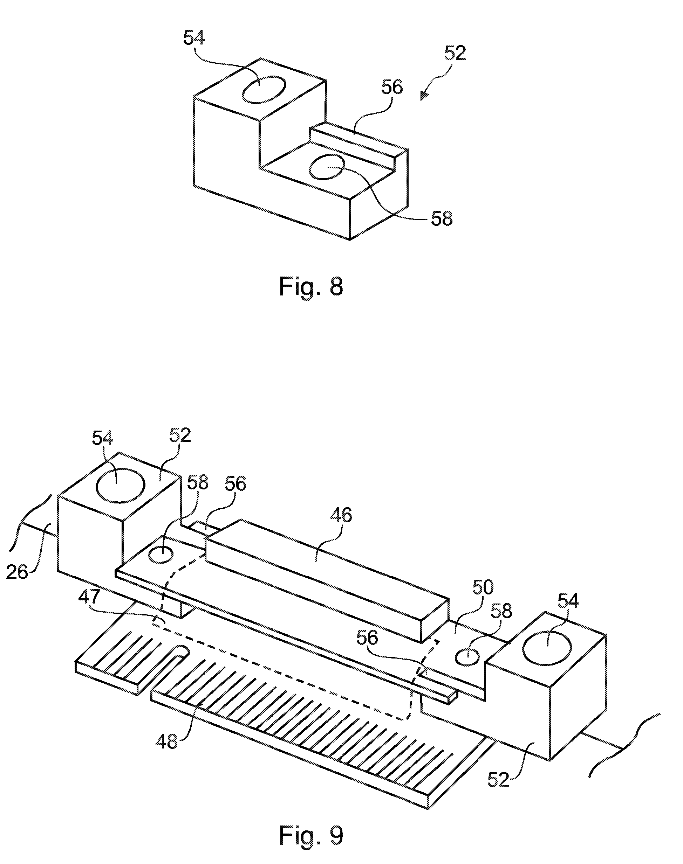

Fig. 8 shows a perspective view of a further embodiment of a support part 52, which comprises two different alignment means for aligning the second rigid board. The alignment means comprise a pin 58 and a fitting strip 56. A bore 54 is provided for receiving a sleeve of an add-in card. In Fig. 9, an adapter with the support part 52 of Fig. 8 is shown. The adapter comprises a first rigid board 48 and a second rigid board 50. A flexible board 47 electrically connects both boards 48 and 50. A part 46 of a high-speed connector is mounted on top of the second board 50. The second board 50 is supported by two separate support parts 52 as shown in Fig. 8. For alignment of the second board 50, the pin 58 is in a hole of the second board 50. Furthermore, the fitting strip 56 is in a recess of the second board 50.

## Claims

1. An adapter (10) for providing an interconnection between an add-in card (26) and a connector slot of a computer system, comprising
a first rigid board (12) having electrical contacts (14) and being adapted to be inserted in the connector slot,
a second rigid board (16) with a first connector part (30) of a connector (28) mounted on one side of the second board (16),
a flexible board (18) attached to one end to the first rigid board (12) and on the opposite end to the second rigid board (16), wherein the flexible board (18) comprises electrical connections (20) connecting the electrical contacts (14) of the first rigid board (12) with electrical contacts of the first connector part (30), and
at least one support part (22, 24; 34) fixedly joining the first and second rigid board (12, 16) and being adapted to be joint with the add-in card (26), wherein the at least one support part (22, 24) is designed such that the first and second rigid board (12, 16) are geometrically offset in that the first connector part (30) is connectable with a second connector part (32) mounted on one side of the add-in card (26), and the first rigid board (12) is aligned with the add-in card (26) so that the add-in card (26) is insertable in the connector slot.

2. The adapter of claim 1, wherein the flexible board (18) is fixed on the side of the second rigid board (16), which is opposite to the side with the first connector part (30).

3. The adapter of claim 1, wherein the flexible board (18) is fixed on the side of the second rigid board (16), on which the first connector part (30) is mounted.

4. The adapter of claim 1, wherein the end of the flexible board (18) is fixed to the second rigid board (16) in that it is "sandwiched" between two layers of the second rigid board (16).

5. The adapter of claim 1, or any of the above claims, wherein the at least one support part (22, 24; 34) comprises alignment means (42; 44) for aligning the adapter (10) with the add-in card (26).

6. The adapter of claim 5, or any of the above claims, wherein the alignment means comprise at least two bores (42, 44) in the at least one support part (22, 23; 34), wherein the at least two bores (42, 44) are adapted to receive sleeves (46) fixedly joint to the add-in card (26).

7. The adapter of claim 1, or any of the above claims, wherein the second rigid board (16) comprises a second first connector part (42) of a connector, mounted on the side of the second rigid board which is opposite to the side, on which the first connector part (30) is mounted.

8. The adapter of claim 1, or any of the above claims, wherein it is a Peripheral Component Interconnect - PCI - Express adapter adapted for insertion in a PCI Express slot of a computer system.

9. The adapter of claim 1, or any of the above claims, wherein the bus specification is PCI Express and the adapter contains one to 16 PCI Express lanes.

10. The adapter of claim 1, or any of the above claims, wherein an add-in card with the adapter complies with PCI Express mechanical specifications.

11. The adapter of claim 1, or any of the above claims, wherein the first connector part (30) is the header of a connector and the second connector part (32) is the socket of the connector.

12. The adapter of claim 1, or any of the above claims, wherein the connector is a high-speed connector adapted to transmit signals in a frequency range up to 2.5 gigabits per second.

13. An add-in card for a connector slot of a computer system, comprising an adapter according to any of the above claims.

14. A computer system comprising a system board with a bus which includes at least one expansion slot comprising an add-in card according to claim 13.
